(19) Europäisches Patentamt / European Patent Office / Office européen des brevets

(11) **EP 2 218 118 B1**

(12) **EUROPÄISCHE PATENTSCHRIFT**

(45) Veröffentlichungstag und Bekanntmachung des Hinweises auf die Patenterteilung:
**30.05.2018 Patentblatt 2018/22**

(51) Int Cl.:
*H01L 33/48* (2010.01)  *H01L 33/44* (2010.01)
*H01L 25/16* (2006.01)  *H01L 25/075* (2006.01)

(21) Anmeldenummer: **08861500.0**

(22) Anmeldetag: **19.11.2008**

(86) Internationale Anmeldenummer:
**PCT/DE2008/001911**

(87) Internationale Veröffentlichungsnummer:
**WO 2009/076922 (25.06.2009 Gazette 2009/26)**

(54) **ANORDNUNG MIT MINDESTENS EINEM OPTOELEKTRONISCHEN HALBLEITERBAUELEMENT**

ARRANGEMENT COMPRISING AT LEAST ONE OPTOELECTRONIC SEMICONDUCTOR COMPONENT

ENSEMBLE MUNI D'AU MOINS UN COMPOSANT SEMI-CONDUCTEUR OPTOÉLECTRONIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **14.12.2007 DE 102007060206**

(43) Veröffentlichungstag der Anmeldung:
**18.08.2010 Patentblatt 2010/33**

(73) Patentinhaber: **OSRAM Opto Semiconductors GmbH**
**93055 Regensburg (DE)**

(72) Erfinder:
• **BOGNER, Georg**
**93138 Lappersdorf (DE)**

• **GRUBER, Stefan**
**93077 Bad Abbach (DE)**
• **ZITZLSPERGER, Michael**
**93047 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:
WO-A-2008/074286     DE-A1- 10 229 067
DE-A1- 10 241 989     DE-A1-102004 045 950
DE-A1-102005 041 064     US-A1- 2001 022 390
US-A1- 2004 256 706     US-A1- 2006 006 793
US-A1- 2006 234 409     US-A1- 2007 194 422

EP 2 218 118 B1

**Beschreibung**

Die Erfindung betrifft eine Anordnung mit mindestens einem optoelektronischen Halbleiterbauelement.

Für elektronische Bauelemente wird eine Vielzahl verschiedener Gehäuse verwendet. Halbleiterbauelemente werden vielfach auf strukturierten metallischen Trägerelementen montiert und in einer Vergussmasse eingespritzt. Wenn Strahlung von außen auf das Gehäuse auftrifft, können an Gehäuseteilen, den Trägerelementen oder an elektronischen Bauteilen Reflexionen auftreten. Bei optoelektronischen Halbleiterbauelementen, an die keine Spannung angelegt ist, kann so der Eindruck entstehen, dass diese Strahlung emittieren.

Es ist eine Aufgabe der Erfindung, eine Anordnung mit mindestens einem optoelektronischen Halbleiterbauelement anzugeben, die besser gegen unerwünschte Reflexionen geschützt ist.

Die Aufgabe wird gelöst durch eine Anordnung mit den Merkmalen des Anspruchs 1. Vorteilhafte Weiterbildungen der Erfindung sind in den zugehörigen abhängigen Ansprüchen angegeben.

Beispiele, die nicht unter die Begriffe der Definition von Anspruch 1 fallen, sind kein Bestandteil der vorliegenden Erfindung, obwohl sie zum Teil in der Beschreibung als "Ausführungsformen" bezeichnet sind. Sie sind lediglich Beispiele, die für das Verständnis der vorliegenden Erfindung hilfreich sind. Eine Anordnung mit mindestens einem optoelektronischen Halbleiterbauelement weist eine zum Tragen des mindestens einen optoelektronischen Halbleiterbauelements geeignete Trägerelementanordnung auf. Bei dem optoelektronischen Halbleiterbauelement kann es sich um ein Strahlung emittierendes Halbleiterbauelement handeln. Die Trägerelementanordnung hat eine Oberfläche, die mindestens eine Anschlussfläche aufweist. Das optoelektronische Halbleiterbauelement ist mit der Anschlussfläche gekoppelt. Die Anordnung weist weiterhin einen aus einem Kunststoff gebildeten Gehäusekörper auf, der an der Trägerelementanordnung angeordnet ist. Der Gehäusekörper weist einen erhöhten Bereich und einen zurückgesetzten Bereich auf. Zwischen dem erhöhten und dem zurückgesetzten Bereich ist eine schräge Flanke gebildet. Der zurückgesetzte Bereich reicht bis an das optoelektronische Halbleiterbauelement. Der Kunststoff ist Licht absorbierend, beispielsweise schwarz.

Insbesondere sind der erhöhte Bereich und der zurückgesetzte Bereich des Gehäusekörpers bevorzugt jeweils zumindest teilweise auf der Trägerelementanordnung angeordnet. Besonders bevorzugt deckt der zurückgesetzte Bereich einen Großteil, beispielsweise 60 % oder mehr, vorzugsweise 70 % oder mehr, bevorzugt 80 % oder mehr, besonders bevorzugt 90 % oder mehr, einer dem Halbleiterbauelement zugewandten Oberfläche der Trägerelementanordnung ab. Der zurückgesetzte Bereich erstreckt sich somit auf der dem Halbleiterbauelement zugewandten Oberfläche der Trägerelementanordnung in lateraler Richtung über die Trägerelementanordnung. Vorzugsweise ist auf der Trägerelementanordnung an einem Montagebereich des Halbleiterbauelements kein Gehäusekörper, insbesondere kein zurückgesetzter Bereich des Gehäusekörpers angeordnet.

Vorzugsweise sind eine von der Trägerelementanordnung abgewandte Oberfläche des zurückgesetzten Bereichs und die Anschlussfläche nicht bündig zueinander angeordnet. Insbesondere überragt der zurückgesetzte Bereich die Anschlussfläche in vertikaler Richtung. Der zurückgesetzte Bereich kann sich zumindest teilweise entlang des Halbleiterbauelements und vom Trägerelement weg erstrecken.

Der zurückgesetzte Bereich reicht bis an das optoelektronische Halbleiterbauelement. Vorzugsweise reicht der zurückgesetzte Bereich unmittelbar bis an das optoelektronische Halbleiterbauelement. Der zurückgesetzte Bereich kann sich dabei unmittelbar entlang des Halbleiterbauelements erstrecken. Insbesondere stehen dann Seitenflächen des zurückgesetzten Bereichs in direktem Kontakt mit Seitenflächen des Halbleiterbauelements. Bevorzugt stehen alle Seitenflächen des zurückgesetzten Bereichs in direktem Kontakt mit den Seitenflächen des Halbleiterbauelements.

Ferner können lediglich Bereiche der Seitenflächen des zurückgesetzten Bereichs unmittelbar an Seitenflächen des optoelektronischen Halbleiterbauelements angeordnet sein. Die Seitenfläche des zurückgesetzten Bereichs und die Seitenfläche des optoelektronischen Halbleiterbauelements stehen dann lediglich bereichsweise in unmittelbarem Kontakt. Beispielsweise sind die Seitenflächen des zurückgesetzten Bereichs zur Trägerelementanordnung hin schräg ausgebildet, sodass lediglich direkt an der Trägerelementanordnung angeordnete Bereiche des zurückgesetzten Bereichs in unmittelbarem Kontakt zu den Seitenflächen des Halbleiterbauelements stehen. In einem nicht erfindungsgemäßen Beispiel kann alternativ ein Abstand zwischen dem zurückgesetzten Bereich und dem optoelektronischen Halbleiterbauelement angeordnet sein. Bevorzugt beträgt der Abstand zwischen dem zurückgesetzten Bereich und dem optoelektronischen Halbleiterbauelement 500 $\mu$m oder weniger, beispielsweise 300 $\mu$m oder weniger, bevorzugt 200 $\mu$m oder weniger, besonders bevorzugt 100 $\mu$m oder weniger. Der zurückgesetzte Bereich kann nur bereichsweise oder umlaufend von dem Halbleiterbauelement beabstandet sein. Die Anschlussfläche der Trägerelementanordnung, mit der das optoelektronische Halbleiterbauelement gekoppelt ist, ist bevorzugt eine elektrische Anschlussfläche für das optoelektronische Halbleiterbauelement. Insbesondere ist das optoelektronische Halbleiterbauelement mit der Anschlussfläche elektrisch leitend verbunden, beispielsweise mittels eines Leitklebers oder eines elektrisch leitfähigen Lotes.

In einer Ausführungsform weist der erhöhte Bereich des Gehäusekörpers eine Höhe und eine Breite auf, die einen Austrittswinkel von 140° oder größer ermöglichen. Innerhalb des Gehäusekörpers, beispielsweise mit dem Trägerelement gekoppelt und von dem Kunststoffmaterial des Gehäusekörpers umgeben, können weitere elektronische Bauteile angeordnet sein. In diesem Fall weist die Oberfläche der Trägerelementanordnung bevorzugt weitere Anschlussflächen auf, die jeweils mit einem weiteren elektronischen Bauteil gekoppelt, insbesondere elektrisch leitend verbunden, sind. Die Trägerelementanordnung umfasst in einer weiteren Ausführungsform ein leitendes Material, insbesondere ein leitendes Metall, beispielsweise Kupfer. Die Trägerelementanordnung kann aus mindestens zwei, zweckmäßigerweise elektrisch leitfähigen, Teilen gebildet sein, die voneinander elektrisch isoliert sind.

Vorzugsweise ist eine Ausbildung des Gehäusekörpers zwischen den mindestens zwei Teilen der Trägerelementanordnung angeordnet. Bevorzugt schließt die Ausbildung des Gehäusekörpers zwischen den mindestens zwei Teilen der Trägerelementanordnung auf der von dem Halbleiterbauelement abgewandten Oberfläche mit der von dem Halbleiterbauelement abgewandten Oberfläche der Trägerelementanordnung ab. Insbesondere überragt die Ausbildung des Gehäusekörpers die Trägerelementanordnung auf einer Unterseite der Anordnung in vertikaler Richtung nicht, so dass die Unterseite der Anordnung flächig ausgebildet ist und insbesondere keine Erhebungen aufweist. Die Unterseite der Anordnung weist so eine ebene Auflagefläche auf, mit der die Anordnung extern montiert werden kann, beispielsweise auf einer Leiterplatte.

Die Anschlussfläche auf der Oberfläche der Trägerelementanordnung beinhaltet in einer Ausführungsform das Zentrum der Trägerelementanordnung.

In einer weiteren Ausführungsform umfasst die Anordnung einen Bonddraht, der mit einer weiteren Anschlussfläche gekoppelt ist und einen elektrischen Anschluss für das optoelektronische Halbleiterbauelement bildet. Der zurückgesetzte Bereich des Gehäusekörpers reicht in dieser Ausführungsform bis an die Anschlussfläche des Bonddrahts.

Die Anordnung kann eine lichtdurchlässige Abdeckung umfassen, die an dem mindestens einen erhöhten Bereich angeordnet ist und das optoelektronische Halbleiterbauelement abdeckt. Die Abdeckung kann ein Absorbermaterial umfassen, um eine Reflexion von von außerhalb der Anordnung auftreffendem Licht zu verringern. Bevorzugt absorbiert das Absorbermaterial dabei nahezu keine von dem Halbleiterbauelement emittierte Strahlung. Inbesondere absorbiert das Absorbermaterial 50 % oder weniger, bevorzugt 30 % oder weniger, besonders bevorzugt 10 % oder weniger der von dem Halbleiterbauelement emittierten Strahlung.

Zu dem gleichen Zweck kann die lichtdurchlässige Abdeckung eine strukturierte Oberfläche aufweisen.

In einer weiteren Ausführungsform umfasst die Anordnung eine lichtdurchlässige Optik, beispielsweise eine Linse, die an dem mindestens einen erhöhten Bereich angeordnet ist und das mindestens eine Halbleiterbauelement abdeckt.

Der mindestens eine erhöhte Bereich umgibt eine Öffnung, in der ein lichtdurchlässiges Füllmaterial angeordnet sein kann. Das Füllmaterial kann ein Diffusermaterial umfassen, um das von dem optoelektronischen Halbleiterbauelement emittierte Licht zu streuen. Das Füllmaterial kann ein Absorbermaterial umfassen, um eine Reflexion von von außerhalb der Anordnung auftreffendem Licht zu verringern. Das Absorbermaterial enthält beispielsweise Ruß oder Graphit. Bevorzugt absorbiert das Absorbermaterial dabei nahezu keine von dem Halbleiterbauelement emittierte Strahlung. Inbesondere absorbiert das Absorbermaterial 50 % oder weniger, bevorzugt 30 % oder weniger, besonders bevorzugt 10 % oder weniger der von dem Halbleiterbauelement emittierten Strahlung.

Vorzugsweise ist das optoelektronische Halbleiterbauelement eine lichtemittierende Diode (LED), insbesondere ein LED-Chip.

Weitere Merkmale, Vorteile und Weiterbildungen ergeben sich aus den nachfolgenden in Verbindung mit den Figuren 1 bis 6 erläuterten Beispielen.

Es zeigen:

Figur 1      eine schematische Darstellung einer Anordnung gemäß einer Ausführungsform,

Figur 2      eine schematische Darstellung einer Anordnung gemäß einer weiteren Ausführungsform mit einer lichtdurchlässigen Abdeckung,

Figur 3      eine schematische Darstellung einer Anordnung gemäß einer weiteren Ausführungsform mit einer Linse,

Figur 4      eine schematische Aufsicht auf eine Anordnung gemäß einer weiteren Ausführungsform mit drei optoelektronischen Halbleiterbauelementen,

Figur 5      eine schematische Aufsicht auf eine Anordnung gemäß einer weiteren Ausführungsform mit drei optoelektronischen Halbleiterbauelementen, bei der ein optoelektronisches Halbleiterbauelement größer als die übrigen optoelektronisches Halbleiterbauelemente ist,

Figur 6      eine schematische Darstellung eines Anwendungsbeispiels, bei dem ein Feld von optoelektronischen Halbleiterbauelementen eine Beleuchtung für einen Display bereitstellt.

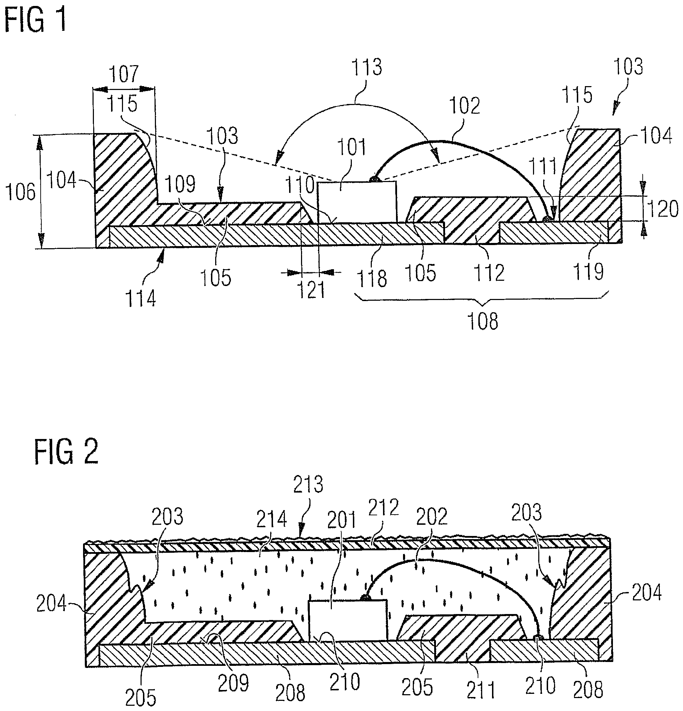

Figur 1 zeigt ein optoelektronisches Halbleiterbauelement 101, einen Bonddraht 102, einen Gehäusekörper 103, und eine Trägerelementanordnung 108. Der Gehäusekörper hat einen erhöhten Bereich 104 und einen zurückgesetzten Bereich 105 sowie eine Flanke 115 zwischen den beiden Bereichen. Die Trägerelementanordnung weist eine Oberfläche 109 auf, die eine Anschlussfläche 110 und eine weitere Anschlussfläche 111 hat.

Insbesondere sind der erhöhte Bereich 104 und der zurückgesetzte Bereich 105 des Gehäusekörpers 103 bevorzugt jeweils zumindest teilweise auf der Trägerelementanordnung 108 angeordnet. Vorzugsweise sind eine von der Trägerelementanordnung abgewandte Oberfläche des zurückgesetzten Bereichs und die Anschlussflächen nicht bündig zueinander angeordnet. Insbesondere überragt der zurückgesetzte Bereich die Anschlussflächen in vertikaler Richtung.

In der gezeigten Ausführungsform umfasst die Trägerelementanordnung einen ersten Teil 118 und einen zweiten Teil 119, die durch eine Ausbildung 112 des Gehäusekörpers elektrisch voneinander isoliert sind.

Vorzugsweise ist die Ausbildung 112 des Gehäusekörpers 103 zwischen den mindestens zwei Teilen 118, 119 der Trägerelementanordnung 108 angeordnet. Bevorzugt schließt die Ausbildung des Gehäusekörpers zwischen den mindestens zwei Teilen der Trägerelementanordnung auf der von dem Halbleiterbauelement abgewandten Oberfläche mit der von dem Halbleiterbauelement abgewandten Oberfläche der Trägerelementanordnung ab. Insbesondere überragt die Ausbildung des Gehäusekörpers die Trägerelementanordnung auf einer Unterseite der Anordnung in vertikaler Richtung nicht, so dass die Unterseite der Anordnung flächig ausgebildet ist und insbesondere keine Erhebungen aufweist. Die Unterseite der Anordnung weist so eine ebene Auflagefläche auf, mit der die Anordnung extern montiert werden kann, beispielsweise auf einer Leiterplatte.

Das optoelektronische Halbleiterbauelement ist auf der Anschlussfläche 110 angeordnet und kann über diese mit einer Spannung versorgt werden. Der Bonddraht ist mit der weiteren Anschlussfläche 111 verbunden und ermöglicht das Anlegen einer Spannung an das optoelektronische Halbleiterbauelement.

Vorzugsweise ist das optoelektronische Halbleiterbauelement eine lichtemittierende Diode (LED), insbesondere ein LED-Chip.

Das Trägerelement kann aus einem leitenden Material, beispielsweise einem Metall, gebildet sein, um eine elektrische Kontaktierung des optoelektronischen Halbleiterbauelements zu ermöglichen. Das Trägerelement kann eine strukturierte Metallschicht sein, beispielsweise aus Kupfer gebildet, die in getrennte Anteile, die elektrisch voneinander isoliert sind, aufgeteilt ist. Das optoelektronische Bauelement kann über Kontaktflächen auf der Unterseite 114 der Trägerelementanordnung elektrisch kontaktiert werden. Die Trägerelementanordnung bildet so einen externen elektrischen Anschluss an dem Gehäuse. In dieser Ausführungsform braucht das Gehäuse nicht mit nach außen geführten streifenförmigen Anschlussleitern versehen zu sein. Die Kontaktflächen auf der Unterseite der Trägerelementanordnung können für einen externen elektrischen Anschluss beispielsweise auf eine Platine aufgelötet werden.

Der Gehäusekörper ist aus einem Material gefertigt, das möglichst wenig Licht reflektiert. Der Gehäusekörper ist beispielsweise aus schwarzem Kunststoff gebildet. Der Gehäusekörper kann aus mehreren Teilen gebildet sein, die an der Trägerelementanordnung angeordnet sind. Der erhöhte Bereich des Gehäusekörpers weist eine Höhe 106 und eine Breite 107 auf. Diese liegen in Bereichen, die einen breiten Austrittswinkel 113 der von dem optoelektronischen Halbleiterbauelement emittierten Strahlung ermöglichen. Der Austrittswinkel kann in einem Bereich von 130° bis 170° liegen, beispielsweise bei 160°. Die Höhe 106 liegt beispielsweise in einem Bereich von 100 $\mu$m bis 300 $\mu$m. Empfänger der emittierten Strahlung sollen in einem möglichst großen Bereich die emittierte Strahlung empfangen können.

Der zurückgesetzte Bereich des Gehäusekörpers deckt möglichst viel Fläche der Oberfläche der Trägerelementanordnung ab. Bevorzugt deckt der zurückgesetzte Bereich einen Großteil, beispielsweise 60 % oder mehr, vorzugsweise 70 % oder mehr, bevorzugt 80 % oder mehr, besonders bevorzugt 90 % oder mehr, der dem Halbleiterbauelement zugewandten Oberfläche der Trägerelementanordnung ab. Er ist von der Flanke des Gehäusekörpers bis an das optoelektronische Halbleiterbauelement beziehungsweise die Anschlussfläche des Bonddrahts gerichtet. Der zurückgesetzte Bereich erstreckt sich somit auf der dem Halbleiterbauelement zugewandten Oberfläche der Trägerelementanordnung in lateraler Richtung über die Trägerelementanordnung.

Der zurückgesetzte Bereich kann nur bereichsweise oder umlaufend von dem Halbleiterbauelement beabstandet sein.

Vorzugsweise ist auf der Trägerelementanordnung an einem Montagebereich des Halbleiterbauelements kein Gehäusekörper, insbesondere kein zurückgesetzter Bereich des Gehäusekörpers angeordnet.

Der zurückgesetzte Bereich weist beispielsweise eine Höhe 120 in einem Bereich von 50 $\mu$m bis 200 $\mu$m auf. Ein Abstand 121 zwischen dem zurückgesetzten Bereich und dem optoelektronischen Halbleiterbauelement beträgt beispielsweise 50 $\mu$m oder mehr, der Abstand liegt beispielsweise in einem Bereich von 150 $\mu$m bis 200 $\mu$m.

Alternativ kann der zurückgesetzte Bereich unmittelbar bis an das optoelektronische Halbleiterbauelement reichen. Der zurückgesetzte Bereich kann sich dabei unmittelbar entlang des Halbleiterbauelements erstrecken. Ferner können lediglich Bereiche der Seitenflächen des zurückgesetzten Bereichs unmittelbar an Seitenflächen des optoelektronischen Halbleiterbauelements angeordnet sein. Beispielsweise sind die Seitenflächen des zurückgesetzten Bereichs zur Trägerelementanordnung hin schräg ausgebildet, sodass lediglich direkt an der Trägerelementanordnung angeordnete Bereiche des zurückgesetzten Bereichs in unmittelbarem Kontakt zu den Seitenflächen des Halbleiterbauelements stehen.

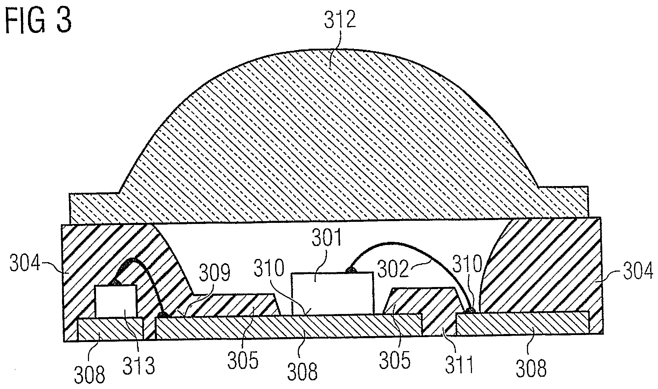

Von dem Gehäusekörper umgeben, auf der Trägerelementanordnung angeordnet, kann, wie in Figur 3 dargestellt, ein zusätzliches elektronisches Bauelement, beispielsweise eine Schutzschaltung gegen Schäden durch elektrostatische Aufladung, enthalten sein. In diesem Fall kann die Höhe 106 in einem Bereich von 200 µm bis 300 µm liegen, sie kann auch bis zu 2 mm betragen. In diesen zusätzlichen elektronischen Bauteilen entstehende Wärme kann durch den schwarzen Gehäusekörper gut abgeführt werden. Der Gehäusekörper hat weiterhin einen geringen Wärmeausdehnungskoeffizienten. Dadurch kann die Verlässlichkeit der weiteren elektronischen Bauelemente erhöht werden.

Die Anschlussflächen der Trägerelementanordnung sind bevorzugt elektrische Anschlussflächen für das optoelektronische Halbleiterbauelement und das elektronbische Bauelement. Insbesondere sind das optoelektronische Halbleiterbauelement und das elektronische Bauelement jeweils mit einer Anschlussfläche elektrisch leitend verbunden, beispielsweise mittels eines Leitklebers oder eines elektrisch leitfähigen Lotes.

Figur 2 zeigt ein optoelektronisches Halbleiterbauelement 201, einen Bonddraht 202, einen Gehäusekörper 203 und eine Trägerelementanordnung 208. Der Gehäusekörper weist einen erhöhten Bereich 204 und einen zurückgesetzten Bereich 205 auf. Die Trägerelementanordnung weist eine Oberfläche 209 auf, die Anschlussflächen 210 beinhaltet. Weiterhin ist eine Abdeckung 212 gezeigt, die eine Oberfläche 213 aufweist. Die Anordnung umfasst ein Füllmaterial 214.

Das optoelektronische Halbleiterbauelement ist mit der Anschlussfläche der Trägerelementanordnung gekoppelt und kann über die Anschlussfläche sowie über den Bonddraht mit Spannung versorgt werden. Eine Ausbildung 211 des Gehäusekörpers trennt die Trägerelementanordnung in zwei Teile und isoliert diese elektrisch voneinander. Um möglichst viele Bereiche der Trägerelementanordnung zu bedecken, ist der zurückgesetzte Bereich des Gehäusekörpers möglichst nah an das optoelektronische Halbleiterbauelement geführt.

Um Reflexionen, die beispielsweise an dem Bonddraht auftreten können, weitestgehend zu verhindern, kann die Abdeckung Absorbermaterial, beispielsweise Ruß, Graphit oder schwarze Pigmente enthalten.

Bevorzugt absorbiert das Absorbermaterial dabei nahezu keine von dem Halbleiterbauelement emittierte Strahlung. Inbesondere absorbiert das Absorbermaterial 50 % oder weniger, bevorzugt 30 % oder weniger, besonders bevorzugt 10 % oder weniger der von dem Halbleiterbauelement emittierten Strahlung.

Zusätzlich kann die Abdeckung eine strukturierte Oberfläche zur weiteren Verminderung von Reflexionen enthalten. Die Abdeckung kann auf einfache Weise, beispielsweise durch eine Klebeverbindung, auf dem erhöhten Bereich des Gehäusekörpers befestigt werden.

In einer von dem erhöhten Bereich des Gehäusekörpers umgebenen Öffnung kann ein transparentes Füllmaterial angeordnet sein. Das Füllmaterial ist beispielsweise bis auf Höhe des erhöhten Bereichs auf dem zurückgesetzten Bereich und dem optoelektronischen Halbleiterbauelement aufgefüllt. Das Füllmaterial kann höher als der erhöhte Bereich sein. Beispielsweise kann das Füllmaterial den erhöhten Bereich um 50 bis 500 µm überragen. In diesem Ausführungsbeispiel ist die Abdeckung auf dem Füllmaterial angeordnet.

Das Füllmaterial kann, um Reflexionen weiter zu verringern, mit einem Absorbermaterial, beispielsweise Ruß oder Graphit, angereichert sein. Das Füllmaterial kann beispielsweise einen Anteil von 0,1% an Absorbermaterial aufweisen, es kann aber auch eine niedrigere Konzentration von weniger als 0,1%, zwischen 0 % und 0,1% haben. Damit können störendes Streulicht sowie Lichtreflexionen verringert werden. Streulicht und Lichtreflexionen können beispielsweise durch die Trägerelementanordnung, elektrische Anschlüsse oder weitere Bauteile der Anordnung verursacht werden.

Um eine möglichst breite Lichtauskopplung zu erreichen, kann das Füllmaterial mit einem Diffusermaterial angereichert sein. Das Diffusermaterial kann beispielsweise eine Konzentration von 10 % des Füllmaterials haben, die Konzentration kann aber auch in einem Bereich von 0 % bis 10 % liegen. Das Diffusermaterial streut die von dem optoelektronischen Halbleiterbauelement emittierte Strahlung. So kann die Fläche der Anordnung, aus der Licht austritt, vergrößert werden. Zur besseren Haftung des Füllmaterials in der Anordnung können in dem Gehäusekörper Aussparungen vorgesehen sein.

Figur 3 zeigt ein optoelektronisches Halbleiterbauelement 301, einen Bonddraht 302, einen erhöhten Bereich 304 und einen zurückgesetzten Bereich 305 des Gehäusekörpers und eine Trägerelementanordnung 308. Die Trägerelementanordnung weist eine Oberfläche 309 auf, die Anschlussflächen 310 umfasst. Der Gehäusekörper weist Ausbildungen 311 auf, die in dieser Ausführungsform zur Begrenzung der Anteile der Trägerelementanordnung angebracht sind. Der Bonddraht ist mit einem Ende mit dem optoelektronischen Bauelement gekoppelt und mit dem anderen Ende mit einer Anschlussfläche der Trägerelementanordnung.

Das Ausführungsbeispiel zeigt ein elektrisches Bauelement 313, beispielsweise eine Schutzdiode, ein Treiberbauelement oder ein Widerstand, das auf der Trägerelementanordnung angeordnet ist. Das elektrische Bauelement kann über die Trägerelementanordnung mit Spannung versorgt werden. Durch die Ausbildung 311 kann die Trägerelementanordnung in elektrisch voneinander isolierte Teile getrennt sein. An das elektrische Bauelement kann über die Trägerelementanordnung eine Spannung von außerhalb der Anordnung angelegt werden.

Das elektrische Bauelement kann vollständig von dem Gehäusekörper umgeben sein. Es können mehrere solcher elektrischen Bauelemente innerhalb des Gehäusekörpers angeordnet sein. Durch die Anordnung der zusätzlichen elektronischen Bauelemente innerhalb des Gehäusekörpers können an den elektronischen Bauelementen keine Reflexionen auftreten.

Die Abbildung zeigt eine Linse 312, die an dem erhöhten Bereich des Gehäusekörpers angeordnet ist. Anstatt der Linse kann eine beliebige Optik angeordnet sein. Die Optik kann beispielsweise durch eine Klebeverbindung auf dem erhöhten Bereich des Gehäusekörpers befestigt sein.

Die Linse kann beispielsweise dazu verwendet werden, den Austrittswinkel des von dem optoelektronischen Halbleiterbauelement emittierten Lichts auf einen gewünschten Bereich einzustellen. In einer Ausführungsform liegt der Austrittswinkel in einem Bereich von unter 40°, er kann beispielsweise in einem Bereich von 20° bis 30° liegen. Prinzipiell kann mit einer entsprechenden Optik ein nahezu beliebiger Austrittswinkel definiert werden.

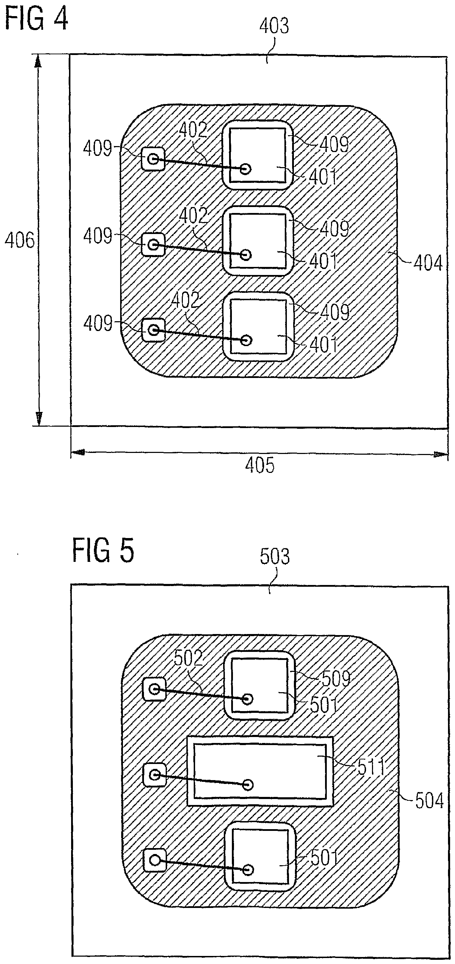

Figur 4 zeigt drei optoelektronische Halbleiterbauelemente 401 mit jeweiligen Bonddrähten 402. Weiterhin ist ein erhöhter Bereich 403 und ein zurückgesetzter Bereich 404 des Gehäusekörpers gezeigt. Sowohl die optoelektronischen Halbleiterbauelemente als auch die Bonddrähte sind mit jeweiligen Anschlussflächen 409 kontaktiert. Der Gehäusekörper weist eine Seitenlänge 405 und eine weitere Seitenlänge 406 auf.

Die Anschlussflächen sind mindestens so groß wie die optoelektronischen Halbleiterbauelemente plus eine Montagetoleranz beziehungsweise mindestens so groß wie die Kontaktierung des Bonddrahts plus eine Montagetoleranz. Die optoelektronischen Halbleiterbauelemente können beispielsweise eine Kantenlänge von 0,2 mm aufweisen, die Montagetoleranz kann in einem Bereich zwischen 10 $\mu$m und 100 $\mu$m liegen.

In dem gezeigten Ausführungsbeispiel sind die drei optoelektronischen Halbleiterbauelemente in einer Reihe angeordnet. Sie können aber auch in einer anderen Anordnung, beispielsweise dreiecksförmig oder rautenförmig, angeordnet sein. Die optoelektronischen Halbleiterbauelemente sind beispielsweise symmetrisch um das Zentrum der Anordnung angeordnet.

Die jeweiligen optoelektronischen Halbleiterbauelemente können Strahlung in unterschiedlichen Wellenlängenbereichen emittieren. Beispielsweise emittiert ein optoelektronisches Halbleiterbauelement Strahlung im grünen Farbbereich, ein weiteres optoelektronisches Halbleiterbauelement Strahlung im blauen Farbbereich und ein weiteres optoelektronisches Halbleiterbauelement Strahlung im roten Farbbereich. Ein Spektrum der resultierenden Gesamtstrahlung kann so aus verschiedenen addierten Spektralbereichen gebildet sein.

Die Gehäusegröße, insbesondere die Maße der Seitenlänge 405 und der Seitenlänge 406, kann entsprechend einer gewünschten Größe dimensioniert werden. Beispielsweise sind die Seitenlängen 6 mm lang, sie können aber auch kürzer sein, beispielsweise 2 mm oder in einem Bereich von 3 mm bis 5 mm liegen.

Werden mehrere der gezeigten Anordnungen benachbart zueinander angeordnet, so können die jeweiligen Seitenlängen an einen gewünschten Abstand der optoelektronischen Bauelemente der jeweiligen Anordnungen angepasst werden. Ist ein Abstand von beispielsweise 5 mm gewünscht, betragen die Seitenlänge 405 und die Seitenlänge 406 jeweils 5 mm, jeweils abzüglich einer Montagetoleranz, die beispielsweise in einem Bereich zwischen 20 und 100 $\mu$m liegt. Bei anderen gewünschten Abständen zwischen den optoelektronischen Halbleiterbauelementen können die Seitenlängen entsprechend festgelegt werden.

Figur 5 zeigt optoelektronische Halbleiterbauelemente 501 mit jeweiligen Bonddrähten 502, ein weiteres optoelektronisches Halbleiterbauelement 511, einen erhöhten Bereich 503 und einen zurückgesetzten Bereich 504 des Gehäusekörpers und Anschlussflächen 509.

Mit den Anschlussflächen sind die optoelektronischen Halbleiterbauelemente und die Bonddrähte gekoppelt. Diese sind von dem zurückgesetzten Bereich des Gehäusekörpers umgeben, der nach außen an den erhöhten Bereich des Gehäusekörpers anschließt. Das optoelektronische Bauelement 511 ist größer dimensioniert als die optoelektronischen Halbleiterbauelemente 501. Anstatt einem größeren Halbleiterbauelement können auch zwei oder mehr optoelektronische Halbleiterbauelemente verwendet werden, die in einem gleichen Wellenlängenbereich emittieren. Dadurch können gewünschte Emissionsbereiche, die beispielsweise im roten Farbbereich liegen, im gesamten Emissionsspektrum der Anordnung verstärkt werden. Unterschiedliche Bereiche können im Emissionsspektrum verschieden stark betont werden.

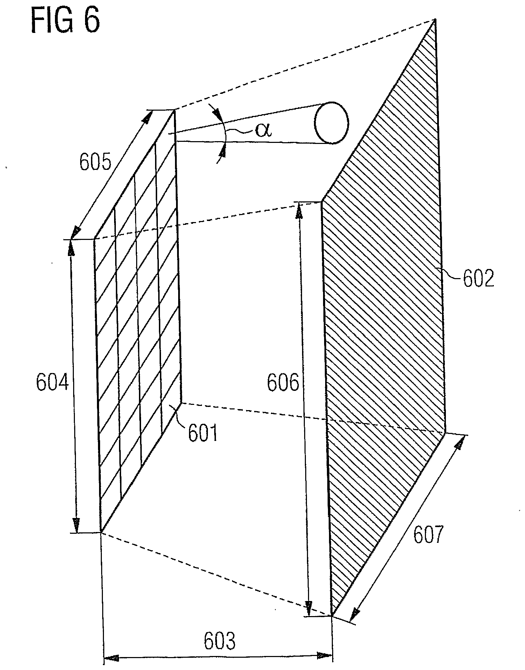

Figur 6 zeigt ein Feld von erfindungsgemäßen Anordnungen 601, mit einer ersten Seitenlänge 604 und einer zweiten Seitenlänge 605 sowie ein Display 602 mit einer Seitenlänge 606 und einer weiteren Seitenlänge 607, das in einem Abstand 603 von dem Feld angeordnet ist. Die Anordnungen umfassen Halbleiterbauelemente, die geeignet sind, bei Anlegen einer Versorgungsspannung Strahlung auszusenden. Sie stellen in dieser Ausführungsform eine Hintergrundbeleuchtung beispielsweise eines Flüssigkristalldisplays dar.

Die Anordnungen sind beispielsweise in einer Matrixanordnung zusammengefasst. Dazu kann zunächst die Größe der jeweiligen Gehäusekörper der Halbleiterbauelemente auf eine gewünschte Größe angepasst werden, beispielsweise abhängig von einem gewünschten Abstand der jeweiligen Halbleiterbauelemente. Der gewünschte Abstand kann beispielsweise 5 mm betragen. Ein Feld mit einer gewünschten Anzahl an einzelnen Anordnungen kann aus einem Feld mit einer größeren Anzahl an Anordnungen vereinzelt werden.

Für ein Display mit einer ersten Seitenlänge 606 von 36 mm und einer zweiten Seitenlänge 607 von 18 mm kann beispielsweise ein Halbleiterfeld mit 4 x 8 Anordnungen verwendet werden. Die minimale Größe des Feldes von Anordnungen (Seitenlängen 604 und 605) kann beispielsweise in Anhängigkeit der Größe des Display (Seitelängen 606 und 607) und des Abstandes 603 von Display und Feld näherungsweise mit folgenden Formeln berechnet werden, wobei $\alpha$ einem Austrittswinkel der emittierten Strahlung einer Anordnung entspricht:

$$l_{604}=l_{606}-2*l_{603}*\tan(\alpha/2) \qquad (1)$$

$$l_{605}=l_{607}-2*l_{603}*\tan(\alpha/2) \qquad (2)$$

Die Anordnungen können jeweils ein einzelnes optoelektronisches Halbleiterbauelement enthalten, sie können aber auch wie beispielsweise in Figur 4 gezeigt, mehrere optoelektronische Halbleiterbauelemente beinhalten. An den jeweiligen Gehäusekörpern kann eine Optik angeordnet sein, wie dies in Figur 3 gezeigt ist. Die Optik ist beispielsweise eine Linse, die einen Abstrahlwinkel zwischen 10° und 30° ermöglicht.

Die Größe des Feldes von Halbleiterbauelementen kann so gestaltet sein, dass die gesamte Leuchtfläche des Feldes in dem Abstand 603 das Display möglichst homogen ausleuchtet. Dazu können über die Linse die Abstrahlwinkel sowie über die Baugröße der Gehäusekörper die Abstände der jeweiligen Halbleiterbauelemente der Anordnungen untereinander passend eingestellt werden. Durch eine Verwendung von erfindungsgemäßen Anordnungen zur Beleuchtung des Displays wird ein hoher Kontrast zwischen beleuchteten und dunklen Bereichen auf dem Display ermöglicht.

**Patentansprüche**

1. Anordnung mit mindestens einem optoelektronischen Halbleiterbauelement (101), umfassend:

   - eine zum Tragen des mindestens einen optoelektronischen Halbleiterbauelements geeignete Trägerelementanordnung (108) mit einer dem optoelektronischen Halbleiterbauelement (101) zugewandten Oberfläche (109), die mindestens eine Anschlussfläche (110) aufweist, mit der das mindestens eine optoelektronische Halbleiterbauelement (101) gekoppelt ist, und
   - einen aus einem Kunststoff gebildeten Gehäusekörper (103), der an der Trägerelementanordnung angeordnet ist, und der mindestens einen erhöhten Bereich (104), mindestens einen zurückgesetzten Bereich (105) und eine schräge Flanke (115) zwischen dem mindestens einen erhöhten Bereich (104) und dem mindestens einen zurückgesetzten Bereich (105) aufweist, wobei sich der zurückgesetzte Bereich (105) auf der dem optoelektronischen Halbleiterbauelement (101) zugewandten Oberfläche (109) der Trägerelementanordnung (108) über die Trägerelementanordnung (108) erstreckt,

   **dadurch gekennzeichnet, dass** der mindestens eine zurückgesetzte Bereich bis an das mindestens eine optoelektronische Halbleiterbauelement reicht und der Kunststoff ein schwarzer Kunststoff ist.

2. Anordnung nach Anspruch 1, wobei der Gehäusekörper (103) aus mindestens zwei getrennten Teilen besteht, die an der Trägerelementanordnung angeordnet sind.

3. Anordnung nach Anspruch 1 oder 2, bei der der zurückgesetzte Bereich (105) des Gehäusekörpers (103) 60 % oder mehr der dem optoelektronischen Halbleiterbauelement (101) zugewandten Oberfläche der Trägerelementanordnung (108) abdeckt.

4. Anordnung nach einem der Ansprüche 1 bis 3, wobei der erhöhte Bereich eine Höhe (106) und eine Breite (107) aufweist, die einen Austrittswinkel (113) des von dem mindestens einen optoelektronischen Halbleiterbauelement (101) emittierten Lichts von 140° oder größer ermöglichen.

5. Anordnung nach einem der Ansprüche 1 bis 4, umfassend einen Bonddraht (102) und mindestens eine weitere Anschlussfläche (111), wobei der Bonddraht einen elektrischen Anschluss für das mindestens eine optoelektronische Halbleiterbauelement (101) bildet und mit der mindestens einen weiteren Anschlussfläche (111) gekoppelt ist, und der mindestens eine zurückgesetzte Bereich (105) des Gehäusekörpers bis an die mindestens eine weitere Anschlussfläche (111) reicht.

6. Anordnung nach einem der Ansprüche 1 bis 5, umfassend mindestens ein elektronisches Bauelement (313), das mit der Trägerelementanordnung (308) gekoppelt ist und vollständig von dem Gehäusekörper (303) umgeben ist.

7. Anordnung nach einem der Ansprüche 1 bis 6, umfassend eine lichtdurchlässige Abdeckung (212), die an dem mindestens einen erhöhten Bereich (204) angeordnet ist und das mindestens eine optoelektronische Halbleiterbauelement (201) abdeckt.

8. Anordnung nach Anspruch 7, wobei die lichtdurchlässige Abdeckung (212) ein Absorbermaterial umfasst, um eine Reflexion von von außerhalb der Anordnung auftreffendem Licht zu verringern.

9. Anordnung nach Anspruch 7 oder 8, wobei die lichtdurchlässige Abdeckung (212) eine Oberfläche (214) aufweist, die strukturiert ist, um eine Reflexion von von außerhalb der Anordnung auftreffendem Licht zu verringern.

10. Anordnung nach einem der Ansprüche 1 bis 6, umfassend eine lichtdurchlässige Optik, insbesondere eine Linse (312), die an dem mindestens einen erhöhten Bereich (304) angeordnet ist und das mindestens eine Halbleiterbauelement (301) abdeckt.

11. Anordnung nach einem der Ansprüche 1 bis 10, umfassend ein lichtdurchlässiges Füllmaterial (215), das in einer von dem mindestens einen erhöhten Bereich umgebenen Öffnung angeordnet ist und das mindestens eine Halbleiterbauelement (201) umgibt.

12. Anordnung nach Anspruch 11, wobei das lichtdurchlässige Füllmaterial (215) ein Diffusermaterial umfasst, um das von dem mindestens einen optoelektronischen Halbleiterbauelement (201) emittierte Licht zu streuen.

13. Anordnung nach Anspruch 11 oder 12, wobei das lichtdurchlässige Füllmaterial (215) ein Absorbermaterial umfasst, um eine Reflexion von von außerhalb der Anordnung auftreffendem Licht zu verringern.

14. Anordnung nach Anspruche 8 oder 13, wobei das Absorbermaterial Ruß und/oder Graphit enthält.

15. Anordnung nach einem der Ansprüche 1 bis 14, umfassend:

   - eine erste Ebene zur Auflage der Anordnung auf eine Fläche;
   - eine zur ersten Ebene beabstandete zweite Ebene, auf der die mindestens eine Anschlussfläche (110) liegt und das mindestens eine optoelektronische Halbleiterbauelement (101) angeordnet ist;
   - eine zur ersten Ebene weiter beabstandete dritte Ebene, durch die eine Oberseite des zurückgesetzten Bereichs (105) des Gehäusekörpers (103) bestimmt ist;
   - eine zur ersten Ebene weiter beabstandete vierte Ebene, bis zu der der erhöhte Bereich (106) des Gehäusekörpers (103) reicht.

**Claims**

1. An arrangement having at least one optoelectronic semiconductor component (101), comprising:

   - a carrier element arrangement (108) which is suitable for carrying the at least one optoelectronic semiconductor component (101) and which has a surface facing (109) the optoelectronic semiconductor component (101), said surface (109) has at least one connection area (110) to which the at least one optoelectronic semiconductor component (101) is coupled, and
   - a housing body (103) which is formed from a plastic and which is arranged on the carrier element arrangement, and which comprises at least one elevated region (104), at least one recessed region (105) and an oblique flank (115) between the at least one elevated region (104) and the at least one set-back region (105), wherein on the surface (109) of the carrier element arrangement (108) facing the optoelectronic semiconductor component (101) the set-back region (105) extends over the carrier element arrangement (108),

   **characterized in that** the at least one set-back region extends to the at least one optoelectronic semiconductor component and the plastic is a black plastic.

2. The arrangement according to claim 1, wherein the housing body (103) consists of at least two separate parts which are arranged on the carrier element arrangement.

3. The arrangement according to claim 1 or 2, in which the set-back region (105) of the housing body (103) covers 60% or more of the surface of the carrier element arrangement (108) facing the optoelectronic semiconductor component (101).

4. The arrangement according to one of claims 1 to 3, wherein the elevated region has a height (106) and a width (107) which enable an exit angle (113) of light emitted by the at least one optoelectronic semiconductor component (101) of 140° or greater.

5. The arrangement according to one of claims 1 to 4, comprising a bonding wire (102) and at least one further connection area (111), wherein the bonding wire is an electrical connection for the at least one optoelectronic semiconductor component (101) and is coupled to the at least one further connecting area, and the at least one recessed region (105) of the housing body extends to the at least one further connection area (111).

6. The arrangement according to one of claims 1 to 5, comprising at least one electronic component (313) which is coupled to the carrier element arrangement (308) and which is completely surrounded by the housing body (303).

7. The arrangement according to one of claims 1 to 6, comprising a light-transmissive cover (212) which is arranged on the at least one elevated region (204) and which covers the at least one optoelectronic semiconductor component (201) .

8. The arrangement according to claim 7, wherein the light-transmissive cover (212) comprises an absorber material in order to reduce reflection of light impinging from outside the arrangement.

9. The arrangement according to claim 7 or 8, wherein the light-transmissive cover (212) has a surface (214) which is structured in order to reduce a reflection of light impinging from outside the arrangement.

10. The arrangement according to one of claims 1 to 6, comprising a light-transmissive optics, in particular a lens (312), which is arranged on the at least one elevated region (304) and covers the at least one semiconductor component (301) .

11. The arrangement according to one of claims 1 to 10, comprising a light-transmissive filling material (215) which is arranged in an opening surrounded by the at least one elevated region and which surrounds the at least one semiconductor component.

12. The arrangement according to claim 11, wherein the light-transmissive filling material (215) comprises a diffuser material in order to scatter the light emitted by the at least one optoelectronic semiconductor component (201).

13. The arrangement according to claim 11 or 12, wherein the light-transmissive filling material (215) comprises an absorber material in order to reduce reflection of light impinging from outside the arrangement.

14. The arrangement according to claim 8 or 13, wherein the absorber material contains carbon black and/or graphite.

15. The arrangement according to one of claims 1 to 14, comprising:

- a first plane for bearing the arrangement on a surface;
- a second plane which is spaced apart from the first plane and on which the at least one connection area (110) and the at least one optoelectronic semiconductor component (101) are arranged;
- a third plane which is further apart from the first plane and by which an upper side of the recessed region (105) of the housing body (103) is defined;
- a fourth plane which is further apart from the first plane and up to which the elevated region (106) of the housing body (103) extends.

## Revendications

1. Ensemble avec au moins un composant semi-conducteur optoélectronique (101), comprenant :

- un ensemble d'éléments porteurs (108) convenant pour porter au moins un composant semi-conducteur optoélectroniques avec une surface (109) tournée vers le composant semi-conducteur optoélectronique (101), laquelle comprend au moins une surface de raccordement (110) avec l'au moins un composant semi-conducteur optoélectroniques (101) est couplé, et
- un corps de boîtier réalisé en matière plastique (103) qui est agencé à l'ensemble d'éléments porteurs et comprend au moins une zone rehaussée ainsi qu'au moins une zone en retrait (105) et un flanc oblique (115) entre l'au moins une zone rehaussée (104) et au moins une zone en retrait (105), la zone en retrait (105) s'étendant sur la surface (109) de l'ensemble d'éléments porteurs (108) tournée vers le composant semi-conducteur optoélectronique (101) au-dessus de l'ensemble d'éléments porteurs (108),

**caractérisé en ce que** l'au moins une zone en retrait s'étendant jusqu'à l'au moins un composant semi-conducteur optoélectronique et le matière plastique étant un matière plastique noir.

2. Ensemble selon la revendication 1, dans lequel le corps de boîtier (103) est composé par au moins deux parties séparées qui sont agencées sur l'ensemble d'éléments porteurs.

3. Ensemble selon l'une quelconque des revendications 1 ou 2, dans lequel la zone en retrait (105) du corps de boîtier (103) couvre 60 % ou plus de la surface de l'ensemble d'éléments porteurs (108) tournée vers le composant semi-conducteur optoélectronique (101).

4. Ensemble selon l'une quelconque des revendications 1 à 3, dans lequel la zone rehaussée présente une hauteur (106) et une largeur (107) qui permettent un angle de sortie (113) de 140° ou plus de la lumière émise par l'au moins un composant semi-conducteurs optoélectronique (101).

5. Ensemble selon l'une quelconque des revendications 1 à 4, comprenant un fil de liaison (102) et au moins une surface de raccordement (111) supplémentaire, le fil de liaison formant un raccord électrique pour au moins un composant semi-conducteur optoélectronique (101) et étant couplé avec l'au moins une autre surface de raccordement (111) et l'au moins une zone en retrait (105) du corps de boîtier s'étendant jusqu'à l'au moins une surface de raccordement (111) supplémentaire.

6. Ensemble selon l'une quelconque des revendications 1 à 5, comprenant au moins un composant électronique (313) qui est couplé avec l'ensemble d'éléments porteurs (308) et entièrement entouré par le corps de boîtier (303).

7. Ensemble selon l'une quelconque des revendications 1 à 6, comprenant un recouvrement (212) transmissive à la lumière, qui est agencé á l'au moins une zone rehaussée (204) et qui couvre l'au moins un composant semi-conducteur optoélectronique (201).

8. Ensemble selon la revendication 7, **caractérisé en ce que** le recouvrement (212) transmissive à la lumière comprend un matériau absorbant afin de réduire une réflexion de la lumière incidente provenant de l'extérieur de l'ensemble.

9. Ensemble selon l'une quelconque des revendications 7 ou 8, **caractérisé en ce que** le recouvrement (212) transmissive à la lumière comprend une surface (214) qui est structurée de manière à réduire une réflexion de la lumière incidente provenant de l'extérieur de l'ensemble.

10. Ensemble selon l'une quelconque des revendications 1 à 6, comprenant une optique transmissive à la lumière, en particulier une lentille (312), qui est agencée à l'au moins une zone rehaussée (304) et qui couvre l'au moins un composant semi-conducteur (301).

11. Ensemble selon l'une quelconque des revendications 1 à 10, comprenant un matériau de remplissage transmissive à la lumière (215) qui est disposé dans une ouverture entourée de l'au moins une zone rehaussée et qui entoure l'au moins un composant semi-conducteur (201).

12. Ensemble selon la revendication 11, **caractérisé en ce que** le matériau de remplissage (215) transmissive à la lumière comprend un matériau diffusant pour diffuser la lumière émise par l'au moins un composant semi-conducteur optoélectronique (201).

13. Ensemble selon l'une quelconque des revendications 11 ou 12, **caractérisé en ce que** le matériau de remplissage (215) transmissive à la lumière comprend un matériau absorbant afin de réduire une réflexion de la lumière incidente provenant de l'extérieur de l'ensemble.

14. Ensemble selon l'une quelconque des revendications 8 ou 13, **caractérisé en ce que** le matériau absorbant contient de la suie et/ou du graphite.

15. Ensemble selon l'une quelconque des revendications 1 à 14, comprenant :

    - un premier plan pour l'appui de l'ensemble sur une surface ;
    - un deuxième plan écarté par rapport au premier plan, sur lequel se trouve au moins une surface de raccordement (110) et sur lequel est agencé l'au moins un composant semi-conducteur optoélectronique (101) ;
    - un troisième plan plus espacé par rapport au premier plan, par lequel une partie supérieure de la zone en retrait (105) du corps de boîtier (103) est définie;
    - un quatrième plan plus espacé par rapport au premier plan jusqu'auquel s'étend la zone rehaussée (106) du corps de boîtier (103).

FIG 1

FIG 2

FIG 3

FIG 4

FIG 5

# FIG 6